# EUROPEAN PATENT APPLICATION

(11) **EP 2 523 227 A1**
(43) Date of publication of application: **14.11.2012**
(21) Application number: 11166078.3
(22) Date of filing: 13.05.2011
(51) Int. Cl.: H01L 31/18, H01L 31/0224, H01L 31/0236, H01L 31/076

(54) **Thin-film solar fabrication process, deposition method for TCO layer, and solar cell precursor layer stack**

(71) Applicant: Applied Materials, Inc., Santa Clara, CA 95054 (US)
(72) Inventor: Sommer, Elisabeth, 63755 Alzenau (DE); Obermeyer, Philipp, 33602 Bielefeld (DE); Zilbauer,Thomas Werner, 63755 Alzenau (DE); Vermeir, Inge, 91077 Neunkirchen (DE); Severin , Daniel, 63477 Maintal (DE); Kuhr, Niels, 63739 Aschaffenburg (DE); Kress, Markus, 63165 Mühlheim (DE); Kurthen Christof, 83052 Bruckmühl (DE); Rembeck, Andreas, 98617 Meiningen (DE); Schmidt, Ursula Ingeborg, 63755 Alzenau (DE); Klein, Stefan, 70771 Leinfelden-Echterdingen (DE); Buschbaum, Suzanne, 63741 Aschaffenburg (DE); Schwanitz, Konrad, 63743 Aschaffenburg (DE); Stoemmer, Christian, 85435 erding (DE); Stolley, Tobias, 61440 Oberursel (DE); Rohde, martin, 10245 Berlin (DE)
(74) Representative: Zimmermann & Partner

(57) **Abstract**

Method of depositing a TCO layer on a substrate, of depositing precursors of a solar cell and precursors of a solar cell are described. The methods includes DC sputtering a ZnO-containing transparent conductive oxide layer over the substrate, the substrate having a size of 1.4 m² or above and texturing the ZnO-containing transparent conductive oxide layer, wherein the textured ZnO-containing transparent conductive oxide layer has a root means square roughness of 60 nm or below.

## Description

### BACKGROUND OF THE INVENTION

### Field of the Invention

Embodiments of the present invention generally relate to depositing TCO layers and texturing TCO layers, particularly for a front contact surface of solar cells. Specifically, they relate to a method of depositing a TCO layer on a substrate, a method of manufacturing a precursor for a solar cell, and a precursor for a solar cell.

### Description of the Related Art

Crystalline silicon solar cells and thin-film solar cells are two types of solar cells. Crystalline silicon solar cells typically use either monocrystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-n junctions. Suitable substrates include glass, metal, and polymer substrates.

To expand the economic uses of solar cells, efficiency must be improved. Solar cell stabilized efficiency relates to the proportion of incident radiation converted into usable electricity. For solar cells to be useful for more applications, solar cell efficiency must be improved beyond the current best performance of approximately above 10% for Si based Thin-film solar modules. With energy costs rising, there is a need for improved thin-film solar cells and methods and apparatuses for forming the same in a factory environment.

Generally, for Si thin film solar cell application, a transparent and conductive oxide layer (TCO) is used as a front contact. In order to improve the efficiency of a solar cell, light trapping is one aspect that can be improved. In order to improve trapping of the photons surface texture at the light entering surface can be utilized. It is accepted as one requirement that the TCO layer has to have a high surface roughness with large lateral feature sizes in order to couple as much as possible of the incoming sun light into the Si absorber. The ZnO that can be used as TCO is texture etched after deposition to achieve a good light scattering effect (haze).

Another aspect for improving mass production of solar cells is the use of large scale processes and the reliability at which processes can be conducted. Thus, there is a desire to improve the processes for increasing the efficiency on a large scale and for applications during industrial manufacturing. For example, high haze ZnO films can be produced via RF-sputter deposition from ceramic targets. However, the RF-technique suffers from a very low deposition rate and the difficulty to scale up the process to large areas.

Further, particularly for tandem junction thin-film solar cell, a balance of the efficiencies, i.e. between the top cell efficiency and the bottom cell efficiency has to be found. Optimizing the plurality of parameters taking into account all possible influences is a highly challenging task. In the past, research has been conducted and there has been a tendency to textured TCO structures with a high haze.

### SUMMARY OF THE INVENTION

In light of the above, a method of depositing a TCO layer on a substrate according to independent claim 1, method of manufacturing a precursor for a solar cell according to claim 7, and a precursor for a solar cell according to independent claim 9 are provided.

Embodiments of the invention provide methods of depositing TCO layers and texturing TCO layers, which take into account an increased number of factors for improved cell efficiencies and, thereby, come to a conclusion, which contradicts the recent developments. According to one embodiment a method of depositing a TCO layer on a substrate is provided. The method includes DC sputtering a ZnO-containing transparent conductive oxide layer over the substrate, the substrate having a size of 1.4 m² or above and texturing the ZnO-containing transparent conductive oxide layer, wherein the textured ZnO-containing transparent conductive oxide layer has a root means square roughness of 60 nm or below. According to typical embodiments, the spectral haze at 550 nm can be about 5 % to 20%.

According to one embodiment a method of manufacturing a precursor for a solar cell is provided. The method includes depositing a TCO layer on a substrate including DC sputtering a ZnO-containing transparent conductive oxide layer over the substrate, the substrate having a size of 1.4 m² or above and texturing the ZnO-containing transparent conductive oxide layer, wherein the textured ZnO-containing transparent conductive oxide layer has a root means square roughness of 60 nm or below. The method further includes depositing a layer stack including at least one p-i-n-junction over ZnO-containing transparent conductive oxide layer, and depositing a back contact layer. According to typical embodiments, the a spectral haze at 550 nm can be about 5 % to 20%.

According to a yet further embodiment a precursor for a solar cell is provided. The precursor includes a substrate having a size of 1.4 m² or above, and a ZnO-containing transparent conductive oxide layer, which is deposited over the substrate by DC sputtering and which is textured, wherein the textured ZnO-containing transparent conductive oxide layer has a root means square roughness of 60 nm or below. According to typical embodiments, the a spectral haze at 550 nm can be about 5 % to 20%.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.

Figure 1 is a schematic side-view of a tandem junction thin-film solar cell according to one embodiment of the invention;

Figures 2A and 2B are schematic side-views of a front surface of a semiconductor precursor illustrating light trapping, which can for example be utilized for a solar cell.

Figures 3A to 3D illustrate the layers deposited on a substrate according to embodiments described herein;

Figure 4 is a schematic flow chart of a method of depositing a TCO on a substrate according to embodiments described herein;

Figure 5A illustrates a portion of a deposited ZnO containing structure for illustrating characteristics as described herein;

Figures 5B and 5C show diagrams for illustrating angle distribution characteristics of solar cell precursors and methods of manufacturing thereof according to embodiments described herein;

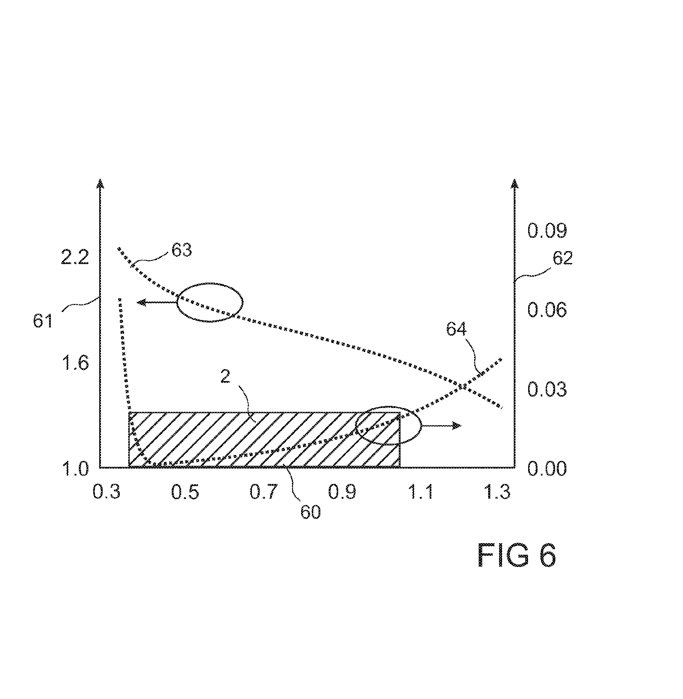

Figure 6 shows further diagrams for illustrating further characteristics of solar cell precursors and methods of manufacturing thereof according to embodiments described herein;

Figure 7 is a schematic side view illustrating an apparatus for depositing a layer stack according to embodiments described herein and for conducting a method according to embodiments described herein; and

Figures 8 is a schematic side view illustrating a yet further apparatus for depositing a layer stack according to embodiments described herein and for conducting a method according to embodiments described herein; and

Figures 9 is a schematic side view illustrating a yet further apparatus for depositing a layer stack according to embodiments described herein and for conducting a method according to embodiments described herein.

To facilitate understanding, identical reference numerals have been used, where possible, to designate identical or similar elements that are common to the figures. It is contemplated that elements and features of one embodiment may be beneficially incorporated into other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The term "substrate" as used herein shall embrace both inflexible substrates, e.g. a wafer or a glass plate, and flexible substrates such as webs and foils. According to some typical embodiments, which can be combined with other embodiments described herein, substrates can be glass substrates, particularly for large are thin-film solar cell manufacturing.

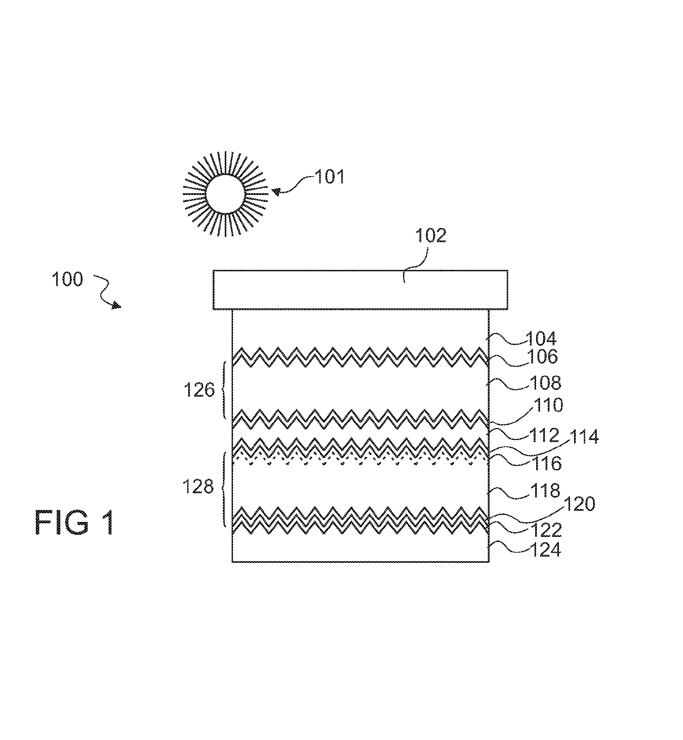

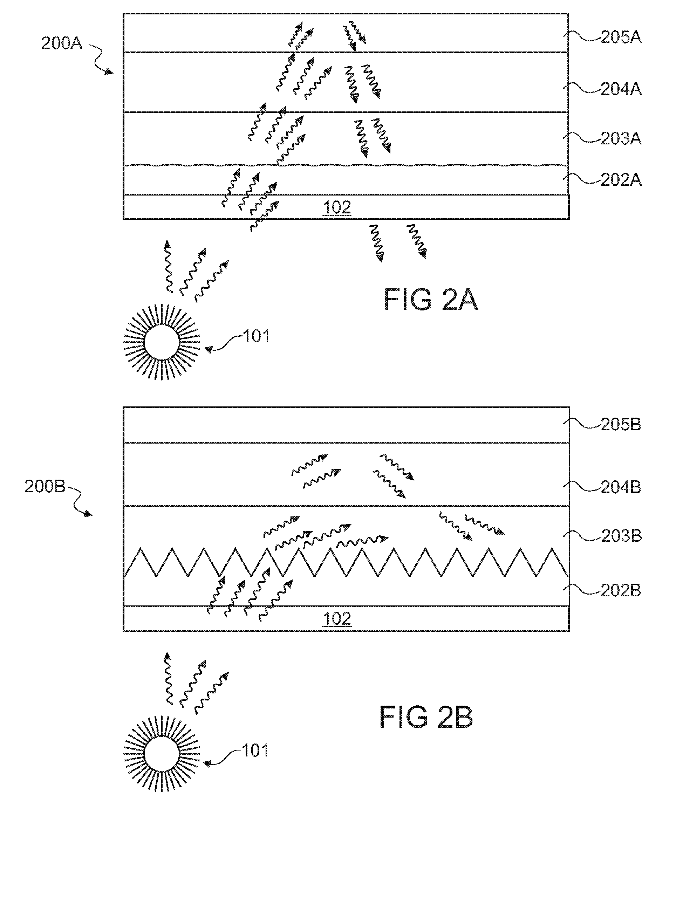

Embodiments described herein relate to processes for the etching of substrate precursors, a method of forming solar cells including etching of substrate precursors, devices for etching substrate precursors, and layer stacks for solar cells being based on substrate precursors with etching processes as described herein. Thereby, reference is for example made to the solar cells as described below and explained in further detail with respect to Figs. 1 and 2.

Thin-film solar cells are generally formed from numerous types of films, or layers, combined in many different ways. Most films used in such devices incorporate a semiconductor element that may comprise silicon, germanium, carbon, boron, phosphorous, nitrogen, oxygen, hydrogen and the like. Characteristics of the different films include degree of crystallinity, dopant type, dopant concentration, film refractive index, film extinction coefficient, film transparency, film absorption, interface morphology and conductivity. Typically, most of these films can be formed by use of a chemical vapor deposition process, which may include some degree of ionization, plasma formation, and/or sputtering processes.

Sputtering is a process in which atoms are ejected from a solid target material due to the bombardment of the target by energetic particles. The process of coating a substrate as a material at the scraping refers typically to thin-film applications. The term "coating" and the term "depositing" are used synonymously herein. The terms "sputtering installation" and "deposition apparatus" are used synonymously herein and shall embrace for example an apparatus which uses sputtering for depositing a target material, typically as a thin-film, on a substrate. Typical target materials include (but are not limited to) pure metals such as aluminum (A1), copper (Cu), silver (Ag) and gold (Au), metal alloys such as an aluminum-niobium (A1Nb) alloy or an aluminum-nickel (A1Ni) alloy, semiconductor materials such as silicon (Si) and dielectric materials such as nitrides, carbides, titanates, silicates, aluminates and oxides, e.g. transparent conducting oxides (TCO) such as impurity-doped ZnO, In₂O₃, SnO₂ and CdO, as well as Sn doped In₂O₃ (ITO) and F doped SnO₂.

According to different embodiments, a plurality of films can be used in solar cells. Charge generation during a photovoltaic process is generally provided by a bulk semiconductor layer, such as a silicon-containing layer. The bulk layer is also sometimes called an intrinsic layer to distinguish it from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon" may refer to any form of silicon having a crystal phase, including microcrystalline and nanocrystalline silicon.

FIG. 1 is a schematic diagram of an embodiment of a multi-junction solar cell 100 oriented toward the light or solar radiation 101. Solar cell 100 comprises a substrate 102, such as a glass substrate, polymer substrate, metal substrate, or other suitable substrate, with thin-films formed thereover. The solar cell 100 further comprises a first transparent conducting oxide (TCO) layer 104 formed over the substrate 102, and a first p-i-n junction 126 formed over the first TCO layer 104. In one configuration, a wavelength selective reflector (WSR) layer 112 is formed over the first p-i-n junction 126. A second p-i-n junction 128 is formed over the first p-i-n junction 126, a second TCO layer 122 is formed over the second p-i-n junction 128, and a metal back layer 124 is formed over the second TCO layer 122. In one embodiment, a WSR layer 112 is disposed between the first p-i-n junction 126 and the second p-i-n junction 128, and is configured to have film properties that improve light scattering and current generation in the formed solar cell 100. Additionally, the WSR layer 112 also provides a good p-n tunnel junction that has a high electrical conductivity and a tailored bandgap range that affects its transmissive and reflective properties to improve the formed solar cell's light conversion efficiency.

To improve light absorption by enhancing light trapping, the substrate and/or one or more of the thin-films formed thereover may be textured by wet, plasma, ion etching, and/or mechanical processes. For example, in the embodiment shown in FIG. 1, the first TCO layer 104 is textured and the subsequent thin-films deposited thereover will generally follow the topography of the surface below it.

The first TCO layer 104 and the second TCO layer 122 may each comprise tin oxide, zinc oxide, indium tin oxide, cadmium stannate, combinations thereof, or other suitable materials. It is understood that the TCO materials may also include additional dopants and components. For example, zinc oxide may further include dopants such as aluminum, gallium, boron, and other suitable dopants. Zinc oxide preferably includes 5 atomic % or less of dopants, and more preferably comprises 2.5 atomic % or less aluminum. In certain instances, the substrate 102 may be provided by the glass manufacturers with the first TCO layer 104 already provided.

The first p-i-n junction 126 may comprise a p-type amorphous silicon layer 106, an intrinsic type amorphous silicon layer 108 formed over the p-type amorphous silicon layer 106, and an n-type microcrystalline silicon layer 110 formed over the intrinsic type amorphous silicon layer 108. In certain embodiments, the p-type amorphous silicon layer 106 may be formed to a thickness between about 60Å and about 300Å. In certain embodiments, the intrinsic type amorphous silicon layer 108 may be formed to a thickness between about 1,500Å and about 3,500Å. In certain embodiments, the n-type microcrystalline semiconductor layer 110 may be formed to a thickness between about 100Å and about 400Å.

The WSR layer 112 disposed between the first p-i-n junction 126 and the second p-i-n junction 128 is generally configured to have certain desired film properties. In this configuration the WSR layer 112 actively serves as an intermediate reflector having a desired refractive index, or ranges of refractive indexes, to reflect light received from the light incident side of the solar cell 100. The WSR layer 112 also serves as a junction layer that boosts the absorption of the short to mid wavelengths of light (e.g., 280nm to 800nm) in the first p-i-n junction 126 and improves short-circuit current, resulting in improved quantum and conversion efficiency. Further, the WSR layer 112 has high film transmittance for mid to long wavelengths of light (e.g., 500nm to 1100nm) to facilitate the transmission of light to the layers formed in the junction 128. Further, it is generally desirable for the WSR layer 112 to absorb as little light as possible while reflecting desirable wavelengths of light (e.g., shorter wavelengths) back to the layers in the first p-i-n junction 126 and transmitting desirable wavelengths of light (e.g., longer wavelengths) to the layers in the second p-i-n junction 128.

In one embodiment, the WSR layer 112 may comprise an n-type doped silicon alloy layer, such as silicon oxide (SiOₓ, SiO₂), silicon carbide (SiC), silicon oxynitride (SiON), silicon nitride (SiN), silicon carbon nitride (SiCN), silicon oxycarbide (SiOC), silicon oxycarbon nitride (SiOCN), or the like. In an exemplary embodiment, the WSR layer 112 is an n-type SiON or SiC layer.

The second p-i-n junction 128 may comprise a p-type microcrystalline silicon layer 114 and, in some cases, an optional p-i buffer type intrinsic amorphous silicon (PIB) layer 116 that is formed over the p-type microcrystalline silicon layer 114. Subsequently, an intrinsic type microcrystalline silicon layer 118 is formed over the p-type microcrystalline silicon layer 114, and an n-type amorphous silicon layer 120 is formed over the intrinsic type microcrystalline silicon layer 118. In certain embodiments, the p-type microcrystalline silicon layer 114 may be formed to a thickness between about 100Å and about 400Å. In certain embodiments, the p-i buffer type intrinsic amorphous silicon (PIB) layer 116 may be formed to a thickness between about 50 Å and about 500 Å. In certain embodiments, the intrinsic type microcrystalline silicon layer 118 may be formed to a thickness between about 10,000Å and about 30,000Å. In certain embodiments, the n-type amorphous silicon layer 120 may be formed to a thickness between about 100Å and about 500Å.

The metal back layer 124 may include, but is not limited to a material selected from the group consisting of A1, Ag, Ti, Cr, Au, Cu, Pt, alloys thereof, or combinations thereof. Other processes may be performed to form the solar cell 100, such as one or more laser scribing processes. Other films, materials, substrates, and/or packaging may be provided over the metal back layer 124 to complete the solar cell device. The formed solar cells may be interconnected to form modules, which in turn can be connected to form arrays.

Solar radiation 101 is primarily absorbed by the intrinsic layers 108, 118 of the p-i-n junctions 126, 128 and is converted to electron-holes pairs. The electric field created between the p-type layer 106, 114 and the n-type layer 110, 120 that stretches across the intrinsic layer 108, 118 causes electrons to flow toward the n-type layers 110, 120 and holes to flow toward the p-type layers 106, 114 creating a current. The first p-i-n junction 126 comprises an intrinsic type amorphous silicon layer 108 and the second p-i-n junction 128 comprises an intrinsic type microcrystalline silicon layer 118 since amorphous silicon and microcrystalline silicon absorb different wavelengths of the solar radiation 101. Therefore, the formed solar cell 100 is more efficient, since it captures a larger portion of the solar radiation spectrum. The intrinsic layer 108, 118 of amorphous silicon and the intrinsic layer of microcrystalline silicon are stacked in such a way that solar radiation 101 first strikes the intrinsic type amorphous silicon layer 118 and is transmitted through the WSR layer 112 and then strikes the intrinsic type microcrystalline silicon layer 118 since amorphous silicon has a larger bandgap than microcrystalline silicon. Solar radiation not absorbed by the first p-i-n junction 126 continuously transmits through the WSR layer 112 and continues to the second p-i-n junction 128.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the p-type and n-type layers 106, 110, 114, 120 described above by including boron-containing or phosphorus-containing compounds in the reaction mixture. Suitable boron and phosphorus compounds generally comprise substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus hydrogen ratios will include hydrogen used as a carrier gas for dopants.

As illustrated with respect to FIGS. 2A and 2B, texturing of layers or films in the semiconductor device can, for example, improve light trapping. FIGS. 2A and 2B show the semiconductor device precursor 200A and 200B, respectively. Layers 202A, 203A, 204A, 205A and 202B, 203B, 204B, 205B respectively, are deposited above the substrate 102. As shown in FIG. 2A, the layer 202A has a flat or almost flat upper surface. In light thereof, a portion of a radiation source 101, such as the sun for a solar cell device, can be reflected within the semiconductor device precursor. This is indicated by a portion of the photons being reflected at the upper surface of layer 205A in FIG. 2A. Thereby, the photons can leave the layer stack for a solar cell after a relative short path length. Contrary thereto, as shown in FIG. 2B, a textured surface 202B increases the likelihood of all, or at least 90 %, of the photons to enter the semiconductor device and can be trapped therein in order to generate electron-hole-pairs. Further, the photons are diffracted at the boundaries of the layers such that the photons might even remain in one layer by total internal reflection upon diffraction at the textured TCO layer. Thereby, the path length within the desired layer in which photons should be absorbed for light conversion is increased. This generally improves the efficiency of the layer stack for the solar cell. As shown in FIGS 2A and 2B, the layer stacks typically have a top cell and a bottom cell, i.e. a top p-i-n junction 203A and 203B, respectively, and a bottom p-i-n junction 204A and 204B, respectively. The top cell is typically the cell, which is closed to the side of a thin-film solar cell at which the solar radiation 101 enters the solar cell. Since this side is typically facing the sun, i.e. is oriented towards the sky in a mounted position of a solar cell under operation conditions, this cell is referred to as the top cell.

As illustrated in FIG. 2B, typically a portion of the photons generate electron-hole pairs in the top cell and a portion of the photons generate electron-hole pairs in the top cell. It is desired to have a larger band gap at the top cell such that low energy photons are less likely to be absorbed in the top and can proceed towards the bottom cell for generation of electron-hole-pairs in the bottom cell. Even though, the boundary surface between layer 203B and 204B is illustrated without any texturing for easiness, there can also be a texturing at this boundary surface for influencing the reflection and the trapping within the top cell and the bottom cell.

Research and development in the recent years has been focused on increasing the haze of the etched TCO layer. Thereby, the focus was primarily to improve efficiency in the bottom cell. The inventors have been found that the overall efficiency can however been further improved if the haze is not maximized. Thereby, more emphasize can be put on the top cell, which can, according to embodiments described herein, be thinner for the reduced haze as compared to the previous attempts with large haze. It has been found that the effect of the thinner top cell experiencing a reduced influence of light induced degradation shows an overall improvement. Further, the thinner top cell increases throughput during manufacturing, which results in an additional beneficial effect of reduced cost of ownership.

According to embodiments described herein, an improved ZnO-containing TCO layer is deposited on an industrially-relevant scale. For example, the TCO layers of some embodiments described herein can be deposited on an area of 3 m² and above, 4 m² and above, or 5 m² and above. Thereby, the surface on which the ZnO-containing TCO layer is to be deposited relates to the above described large area substrates, which are to be processed in industrial applications. Accordingly, it has to be considered that in the last decades a plurality of research has been conducted in the area of solar cells and a plurality of results have been achieved on a laboratory scale. However, particularly in light of the desire to increase the amount of renewable energy production, it has to be considered that processes need to be established that can be conducted on industrial scale and under industrial conditions. It has become apparent that many of laboratory standard research results independent of their quality, i.e. very good or very poor, of the last years have failed when being transferred on industrial scale and/or under industrial conditions. The embodiments described herein have been demonstrated on industrial scale and under industrial conditions.

According to embodiments described herein, the haze of the TCO layer after etching can be in a range of 5 % to 20 %. Typically, the haze referred to herein is to be understood as mostly done in the art, namely as a spectral haze at 550 nm, wherein 100% corresponds to all transmitted light has been scattered, whereas 50% would result in a ratio of 1:2 between scattered transmitted light and all transmitted light. That is the haze, e.g. at 550 nm can be measured as the ratio of diffuse Transmission / total Transmission and typically by utilizing a integrating sphere (Ulbricht sphere).

According to yet further embodiments, the TCO structures as described herein, include smaller craters, i.e. craters with a smaller lateral distance. For example, the craters can have a distribution with an average lateral distance between craters of for example from 200 to 500 nm. According to yet further embodiments, the feature size of the craters has a first distribution with a first feature size of, e.g., 400-700 nm and superimposed craters with a feature size of the superposed structure being 50 nm to 200 nm, e.g. 50-100nm. According to yet further embodiments, which can be combined with other embodiments described herein, the root mean square roughness can be 60 nm or below, e.g. from 10 nm to 60 nm, typically 50 nm or below, such as from 30 nm to 50 nm. This results in better light in-coupling and/or scattering of small wavelength photons and, thus, in the above described focus of top cell efficiency.

Generally, the crater distribution can be described by a power spectral density (PSD) in order to define the distribution of the features sizes of craters after texturing of a TCO layer. Thereby, typically a 2D-isotropic PSD can be defined based on a Fourier transformation. According to typical embodiments described herein, a TCO layer can be provided with a 2D isotropic PSD, which has a first value at a wavelength of 500 nm and a second value at a wavelength of 1100 nm, wherein the second value is larger than the first value by an order of magnitude or less. The increase of the PSD value for smaller wavelength results in increased light in-coupling and/or scattering for shorter wavelength photons, which are intended to generate electron-hole pairs in the top cell.

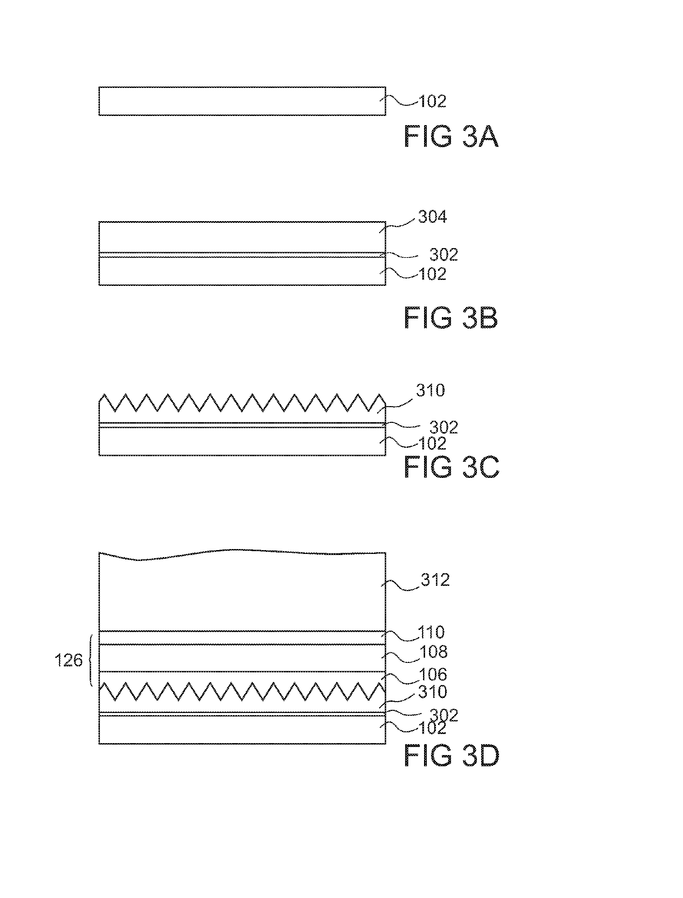

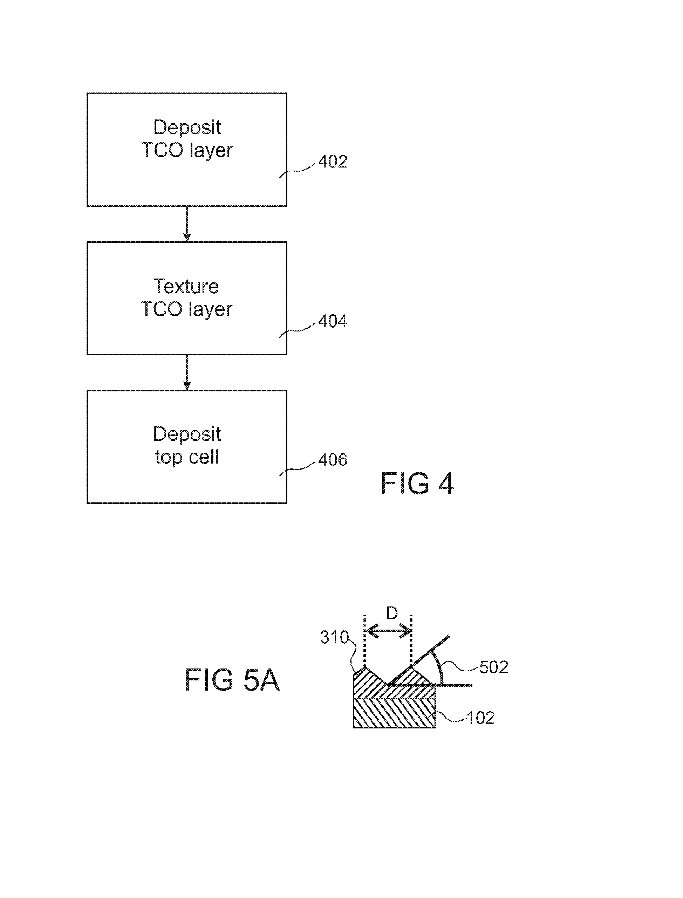

Typical embodiments are, for example, shown in FIGS. 3A to 3D, which are described in the following while referring to the method illustrated in FIG. 4. FIG. 3A shows a substrate 102 which can be provided for depositing a TCO layer. According to some embodiments, the TCO layer can be used as a front contact layer of a thin-film solar cell. A barrier layer 302 can be deposited on the substrate. The barrier layer 302 can be conditioned such that a seed layer or corresponding seeds are provided on the barrier layer. Examples of a conditioning of a layer for depositing a TCO layer thereon are described in EP patent application No. 10169889 , entitled " Thin-film Solar Fabrication Process, Deposition method for TCO layer, and Solar cell precursor layer stack" filed on July 16, 2010, which is incorporated herein by reference to the extent the applications are not inconsistent with this disclosure. Therein, for example, a method of depositing a TCO layer on a substrate is provided. The method includes providing a glass substrate having a first alkali metal concentration and conditioning the glass substrate, wherein the conditioning comprises at least one step selected from the group consisting of: applying a liquid to the substrate to form a layer with a second alkali metal layer concentration higher than the first alkali metal concentration, and depositing a layer to form a layer with a second alkali metal layer concentration higher than the first alkali metal concentration, wherein the method can further include depositing a TCO layer over the conditioned substrate. Thereby, according to different embodiments, which can be used alternatively to each other or in combination with each other, the conditioning step provides a defined concentration of alkali metals on the surface on which the zinc oxide layer 304 (see FIG. 3B) is deposited. Thereby, an alkali metal-containing seed layer can have a thickness of 5 nm or below or can be even less than 1 nm. Accordingly, even though reference is made to a layer, the seed layer might not be a fully closed layer but might be a plurality of seeds or seed islands. It is to be understood that a thin layer with a thickness of only a few atoms will not continuously grow over the entire surface. Typically, the nucleation of a layer starts at several positions on a surface and a few atomic layers might build up in areas around those positions before the entire layer covers the surface to be coated. Thus, according to embodiments described herein, a seed layer might not necessarily fully cover the surface below.

In step 402, the TCO layer 304, typically a ZnO-containing layer, is deposited on the layer stack or on the substrate respectively. Accordingly, the solar cell precursor shown in FIG. 3B is provided after step 402. In step 404, the TCO layer is textured resulting in the solar cell precursor shown in FIG. 3C. Therein, the textured ZnO containing TCO layer 310 is shown.

According to some embodiments, which can be combined with other embodiments described herein, the solar cell precursors, the methods and devices for etching semiconductor device precursors, such as solar cell precursors, can be utilized for large area thin-films. For example, substrate sizes of 1.43 m² (Gen5) and above, of 2.8 m² and above, e.g. of 5.7 m² (Gen8.5) or larger can be realized. Further typical embodiments relate to aluminum doped zinc oxide layers (ZnO:A1) as a TCO, which can be sputtered from rotatable ceramic zinc oxide aluminum oxide (ZnO:Al₂O₃) targets. Typically, the aluminum doped zinc oxide layers form a front contact of a solar cell. According to yet further embodiments, the TCO layer can be wet-chemically etched, for example in diluted hydrochloric acid, or other suitable etchants. Thereby, as described above, the etching process is of importance for the surface texture, which is used to scatter the light. As compared to the previous attempts to couple particularly the long wavelength light in the VIS and NIR range, embodiments described herein increase light in-coupling and/or scattering for short wavelength light of e.g. 700 nm and below or 600 nm or below. This can for example be provided in light of an improved refraction index matching of the layers for shorter wavelength.

Typically, the shape and feature size of the etched semiconductor layer depends on the parameters of the layer as well as the etching process. Accordingly, for a predetermined semiconductor layer with certain characteristics, the nucleation of the layer to be etched needs to be controlled such that the desired texture of the layer is generated. According to different embodiments, the texturing can be conducted by a wet etching process or a dry etching process. According to yet further implementations, the etching process can be an isotropic or an anisotropic etching process. Typically, the texturing step 404 can be provided by etching the zinc oxide-containing TCO layer with a diluted acid in order to roughen the ZnO surface by wet etching.

After texturing the TCO layer in step 404, silicon layers 106, 108 and 110 forming the top cell are deposited in step 406. According to typical embodiments, the silicon layer 106 can be a p-type silicon layer, for example a p-type amorphous silicon layer 106 shown in FIG. 1, the silicon layer 108 can be an intrinsic silicon layer, for example intrinsic type amorphous silicon layer 108 shown in FIG. 1, and the silicon layer 110 can be an n-type silicon layer, for example an n-type microcrystalline silicon layer 110 shown in FIG. 1. Generally, one or more p-n-junctions are deposited on the TCO layer. Thereby, the textured TCO layer 310 forms the front contact of a precursor of a thin-film solar cell.

According to some embodiments, which can be combined with other embodiments described herein, the thickness of the top cell can be reduced in light of the increased short wavelength in-coupling. For example, the thickness of the top cell 126 can be 350 nm or less and/or the thickness of the intrinsic layer can be from 100 to 280 nm, e.g. can be 250 nm or less, whereas the p-type layer thickness can be 30 nm or less and the n-type layer thickness can be 40 nm or less. The thickness, which is reduced as compared to lately developed research strategies results in a reduced light induced degradation and, thus, in an increased efficiency of a solar cell module for commercial purposes.

As described above, a plurality of laboratory standard layer stacks have been grown, e.g. with RF sputtering methods. However, there is a need to provide a desired TCO layer with high deposition rates and, accordingly, increased throughput. Therefore, according to embodiments described herein, DC sputtering of ZnO-containing TCO layers and texture etched ZnO-containing layers can be provided to enable industrial relevant scale and industrial relevant condition processes for TCO layers on substrates sizes of GEN5 or larger or even GEN 8.5 or larger.

According to typical embodiments, a SiON buffer layer with a thickness of below 100 nm can be deposited on a washed glass substrate by reactive sputtering. After that, a doped ZnO layer is deposited by DC-sputtering as TCO front contact, which can be, for example, approx. 600 - 1000 nm thick, such as 600 nm — 900 nm. The doping is usually provided but not restricted to aluminum. The layer stack can be etched in diluted acid in order to roughen the surface of the ZnO film by wet etching.

It is commonly accepted that the deposition parameters of the ZnO layer such as pressure and temperature, amongst others, have a pronounced impact on the nucleation of the TCO layer and/or on the surface morphology after etching. This influences the efficiency of the solar module. Compared to the state of the art the RF-process, the DC-sputter process according to embodiments described herein, allows very high deposition rates and an easy scalability to large areas. Further, it has been shown in previous attempts that under some circumstances high haze ZnO films can be obtained with the DC process. However, there have been increasing difficulties to demonstrate high haze ZnO deposition on industrial scale and industrial conditions, e.g. on large area substrates. Yet, it is possible to deposit ZnO layers with medium haze within a stable DC-sputter process window and homogenously over the entire substrate. Devices on these substrates do not have not experienced as good efficiencies and power as reported from the high haze material. According to embodiments described herein, ZnO-containing TCO layers can be produced on large area substrates, i.e. on industrial relevant scale and under industrial relevant conditions such as throughput, within a process window that allows for a ZnO structure with comparable low haze which can be produced with DC sputtering, e.g. on large scale Gen 5 and/or Gen 8.5.

According to embodiments described herein, an improved ZnO structure for TCO layers, particularly for front contacts of thin-film solar cells are provided. This ZnO structure according to embodiments described herein, shows excellent cell results when tandem junction solar cells are produced. The results are a long-desired improvement as compared to the above mentioned high haze ZnO structures with a haze of e.g. 50% or above. The ZnO-containing TCO structure according to embodiments described herein, which has not the coveted high haze structure after etching, can be utilized for certain layer stacks, e.g. layer stacks with relatively low top cell (TC) thickness, wherein the thickness of the intrinsic layer of the TC is 280 nm or less and, thereby can result into excellent results for thin film Si based solar cells. Furthermore, the structure can easier be produced homogeneously on large scale, which has been demonstrated on Gen 8.5 with 2,20m x 2,60m in size.

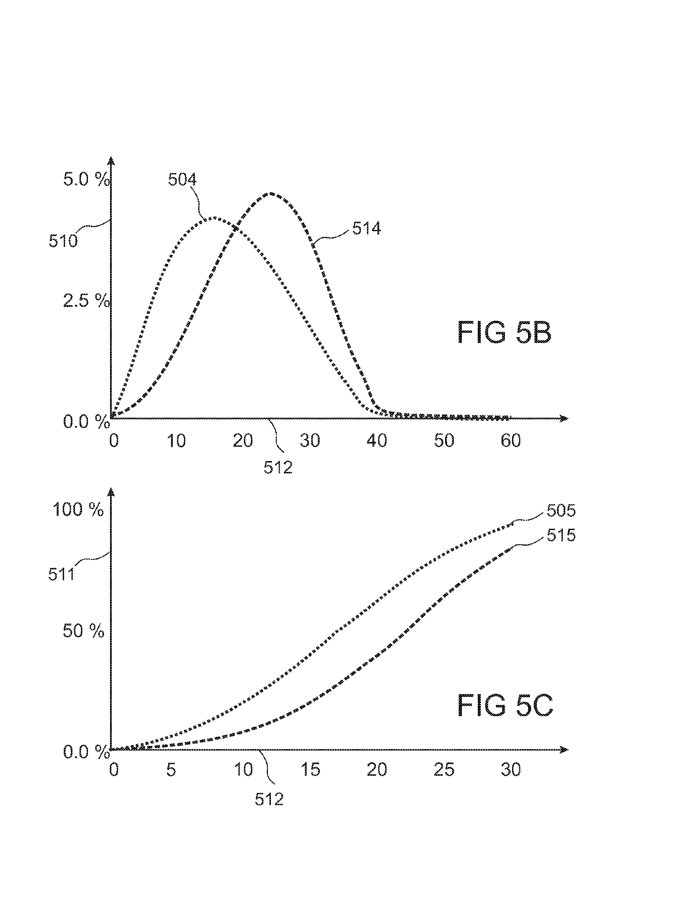

FIG. 5A illustrates a substrate 102 and a textured ZnO-containing TCO layer, e.g. an aluminum doped zinc oxide layer (ZnO:Al). As shown in FIG. 5A, the optional buffer layer shown e.g. in FIG. 3B can be omitted. The TCO layer shown exemplarily in FIG. 5a shows one crater with an exemplary lateral feature size D, which is indicated by reference numeral 501. Further, the texture angle α is indicated by the angle 502. FIGS. 5B and 5C illustrate the texture angle distribution according to some embodiments described herein. Within FIGS. 5B and 5C, curves 504 and 505 illustrate the angle distribution of the texture ZnO containing TCO structures, which has previously been aimed for. Thereby, curve 504 illustrates the angle distribution as a function of the angle, wherein the ordinate 510 provides the probability and the abscissa 512 the angle. Curve 505 illustrates the cumulative distribution function as a function of the angle, wherein the ordinate 511 provides the cumulative distribution function and the abscissa 512 the angle.

As compared thereto, the new ZnO-containing TCO structures according to some embodiments described herein show angle distributions as shown by curves 514 and 515, respectively. Thereby, curve 514 illustrates the angle distribution as a function of the angle, wherein the ordinate 510 provides the probability and the abscissa 512 the angle. Curve 515 illustrates the cumulative distribution function as a function of the angle, wherein the ordinate 511 provides the cumulative distribution function and the abscissa 512 the angle. As can be seen, the angle distribution of the embodiments described herein are shifted towards higher angles as compared to the previous "high-haze" structure. As can be seen by FIGS. 5B and 5C, according to some embodiments, the probability has a maximum of a texture angle α (measured relative to the substrate plane as indicated in FIG. 5A ), which is larger than 15°, for example about 19° or larger, typically 20° or larger, e.g. 23°. According to further embodiments, which can be combined with other embodiments described herein, the cumulative distribution function of texture angle α (measured relative to the substrate plane as indicated in FIG. 5A) has values of P(α <10°) of 15% or smaller, typically of 10% or smaller, e.g., of about 8% and/or P(α <20°) of 55% or smaller, typically of 45% or smaller, e.g. about 38%.

According to yet further embodiments, which can be combined with other embodiments described herein, the ZnO containing TCO layer, e.g. ZnO:Al, can also be characterized by one or more of the following characteristics: the spectral haze at 550 nm can be for example as low as about 5%, typically the spectral haze at 550 nm can be in the range of 5-20%, such as 8 % to 15%; the sheet resistance after etching can be as high as 30 Ohm, typically sheet resistance after etching can be 7 Ohm to 25 Ohm, such as 9 Ohm to 15 Ohm; the extinction coefficient k for wavelenghts between 400 nm and 1300 nm can be 0.05 or less (e.g. k<0.05), the extinction coefficient k for wavelenghts between 400 nm and 1000 nm can be 0.02 or less (e.g.k<0.02), typically the extinction coefficient k for wavelenghts between 400 nm and 1000 nm can be 0.015 or below; and combinations thereof. According to yet further embodiments, the methods of manufacturing according to embodiments described herein, have a higher etching speed in comparison to the previously desired high haze ZnO ( high haze material, e.g., > 50% haze) when using the same etching solution.

According to yet further embodinents, the ZnO-containing TCO structure can be produced on large areas using DC sputtering. Thereby, typically a SiON buffer layer with a thickness of 100 nm or below is deposited on a washed and heated glass substrate by reactive sputtering. A doped ZnO layer is deposited by DC-sputtering as TCO front contact and having a thickness of about 600 - 1000 nm thick, such 600 nm-900 nm. The doping can be, but is not restricted to aluminum. The layer stack can then be etched in diluted acid in order to roughen the ZnO surface by wet etching.

Typically, the deposition parameters of the ZnO layer, such as e.g. pressure, measured substrate temperature as compared to effective temperatures during deposition (not measured), substrate temperatures during deposition, target compositions, deposition system dimensions and designs (such as target substrate distances), gas mixtures, sputter power and the like have an impact on the surface morphology after etching and therefore on the efficiency of the solar module. In light of the plurality of parameters and, particularly, the interaction thereof, the desired layer characteristics can be provided with a plurality of sets of parameters. For example, the desired layer characteristics can be provided by the following example: The process can be conducted on ATON 5.7 TCO available from Applied Materials, Inc., located in Santa Clara, CA. The glass is loaded and heated to about 220°C. A SiON layer is deposited in one or more modules, e.g. with 45 kW MF sputtering from double rotatable cathodes, an Ar/N2/02 gas mixure with 500, 600 and 200 sccm, respectively is provided at a total pressure of 0.3 Pa. The substrate is further heated to about 300°C to 310 °C, e.g. 305°C. A ZnO:Al layer with a thickness of 850 nm is deposited from a ZnO- and Al₂O₃-containing target comprising 1 weight-% Al₂O₃. This can be done in one or more machine modules e.g. with 2*54 kW DC sputtering from double rotatable cathodes, and Ar flow of 500 sccm and a pressure of 0.25 Pa. After unloading and cooling the layer can be etched about 20s in 0.3 % HC1 at 28°C.

According to yet further embodiments, the TCO layers, the solar cell precursors, and the methods of manufacturing are particularly applicable for Si based thin film device structure, e.g. tandem junction Si based thin film solar cells. Thereby, improvements of solar cell efficiency can be realized. This is, for example, due to shifting the balance of top cell and bottom cell towards the top cell by providing TCO structures with the herein-described characteristics, such as haze. Accordingly, higher top cell currents can be reached. This allows the reduction of the TC thickness, which reduces the effect of light induced degradation and increases the overall efficiency and the throughput of modules and hence the cost of ownership.

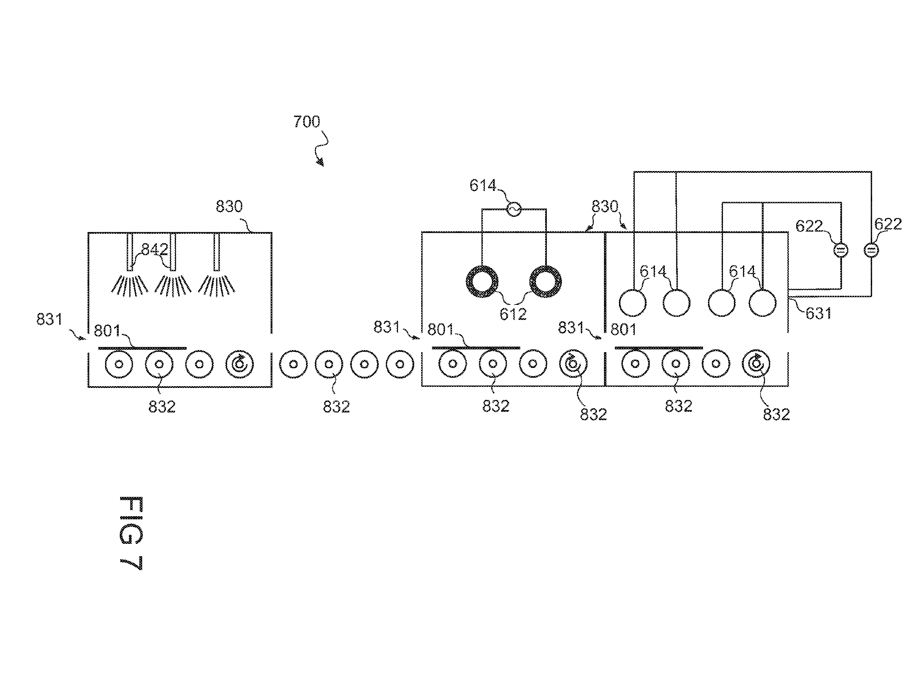

FIG. 7 illustrates an apparatus for depositing a TCO layer according to embodiments described herein. The apparatus 700 includes two or more chambers 830 or respective compartments. A transport system with, for example, rollers 832 for transporting a substrate 801 through the system 700 is provided. Typically, the chambers have openings 831 for introducing the substrate 801 into the chamber and transferring the substrate into a subsequent chamber or out of the chamber. According to typical embodiments, the openings 831 can be sealed with valves during operation of the system 800.

As shown in FIG. 7, nozzles 842 for spraying a detergent on the substrate 801 can optionally be provided in the first chamber of the chambers 830. According to alternatives embodiments, the cleaning step with water and/or a detergent can also be conducted in a bath. The substrate or the layer stack can be polished, can be cleaned and/or conditioned with alkali metal seeds or an alkali metal seed layer. Thereafter, it is transported towards the second chamber 830, whereby for example a drying process might be conducted, and is transferred into the second chamber 830.

According to other embodiments, in the first chamber of the chambers 830, sputter cathodes, such as rotatable sputter cathodes, can be provided to deposit a barrier layer or a seed layer, for example such that an alkali metal concentration is controlled and increased as compared to the surface concentration of the glass substrate. According to alternative implementations, the seeds or the seed layer can also be provided by a CVD process, such as a PECVD process.

Alternatively or additionally, respectively, a first chamber (or second chamber, respectively,) can include sputtering cathodes, such as rotatable sputtering cathodes, for sputtering. For example, a barrier layer such as a SiON barrier layer, which can be reactively sputtered, can be provided on the conditioned substrate in the second chamber. Thereafter, the TCO layer, such as a zinc oxide layer, is DC sputtered on the barrier layer. Thereby, a TCO layer, which can be textured in the subsequence processing step such as a wet etching step, is deposited over the substrate.

A system 700 can further have a polishing station such that the first 5-20 nm of the substrate are removed in a polishing step before the substrate is cleaned, condition with an alkali-metal seed layer and/or a barrier layer is deposited thereon.

FIG. 7 further illustrates sputtering cathodes 612, such as rotatable sputtering cathodes, which can be provided in one of the chambers 830. A power supply 614 provides power for the middle frequency sputtering process for depositing the layer 302 shown e.g. in FIG. 3B. According to some embodiments, which can be combined with other embodiments described herein, the middle frequency sputtering having frequencies in the range of 5 kHz to 100 kHz, for example, 30 kHz to 50 kHz, can be provided for manufacturing one or more layers of the solar cell layer stack.

After the buffer layer has been deposited, the substrate is transferred in the further chamber 830. The further chamber includes sputtering cathodes 614, such as rotatable sputtering cathodes, for sputtering the ZnO-containing TCO layer on the substrate 801. Thereby, a TCO layer, which can be textured in the subsequent processing step such as a wet etching step, is deposited over the substrate.

As shown in Fig. 7, the TCO sputtering process is a DC sputtering process, wherein one or more power supplies 622 provide a DC voltage between the respective cathodes 614 and, for example, the chamber wall 631. According to typical embodiments, which can be combined with other embodiments described herein, each cathode can have a corresponding power supply, each double cathode can have a corresponding power supply, or at least some cathodes might share power supplies. According to alternative embodiments the DC voltage might also be provided between the cathodes and separate anodes. According to yet further alternative or additional modifications, pulses might be added to the DC voltage, for example by a second power supply.

System 700 can further include, as additional optional modifications, one or more load lock chambers (not shown), which allows substrates to be transferred between the ambient environment outside the system and the vacuum environment within the in-line processing system provided by chambers 830. The load lock chamber includes one or more evacuatable regions holding one or more substrates. The evacuatable regions are pumped down during input of substrates into the system and are vented during output of the substrates from the system.

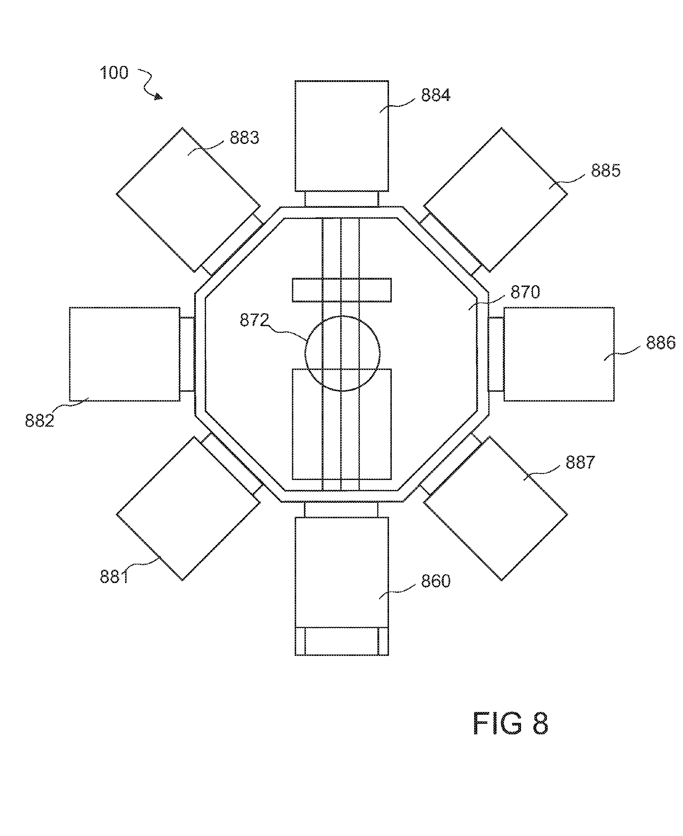

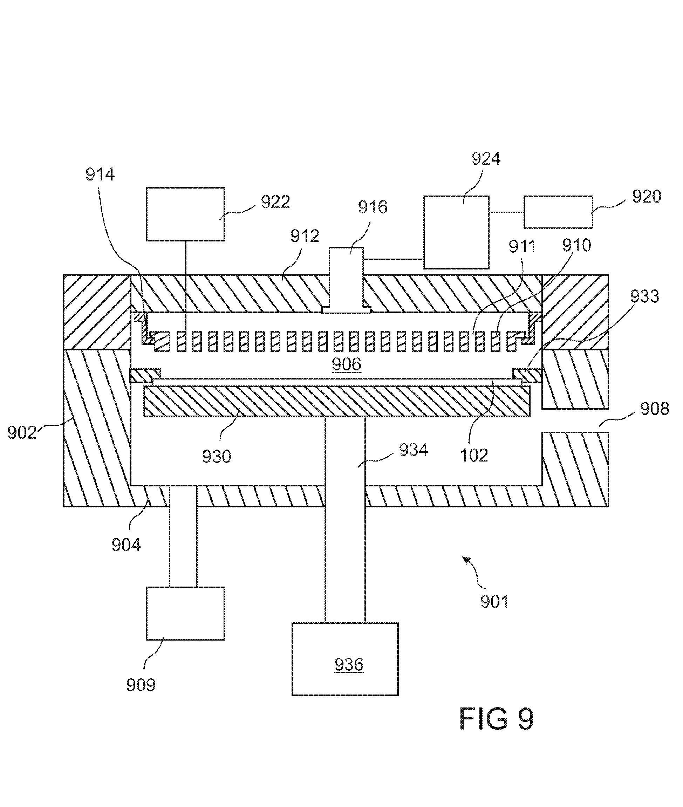

Figures 8 and 9 illustrate a processing system 800 and a processing chamber 901 that may be used to form a portion of the solar cell, discussed above. Figure 8 is a top schematic view of one embodiment of a processing system 800, which may be one of the one or more cluster tools. The processing system 800 can thus be used to perform one or more processing steps that are used to form the various layers or regions of the solar cell device. The processing system 800 will generally contain a plurality of process chambers 881-887, such as a plasma enhanced chemical vapor deposition (PECVD) chamber 901 (Figure 9), capable of depositing one or more desired layers onto the substrate surface. The process system 800 includes a transfer chamber 870 coupled to a load lock chamber 860 and the process chambers 881-887. The load lock chamber 860 allows substrates to be transferred between the ambient environment outside the system and the vacuum environment within the transfer chamber 870 and process chambers 881-887. The load lock chamber 860 includes one or more evacuatable regions holding one or more substrates. The evacuatable regions are pumped down during input of substrates into the system 800 and are vented during output of the substrates from the system 800. The transfer chamber 870 has at least one vacuum robot 872 disposed therein that is adapted for transferring substrates between the load lock chamber 860 and the process chambers 881-887. While seven process chambers are shown in Figure 8, the system 800 may have any suitable number of process chambers.

Figure 9 is a schematic cross-section view of one embodiment of a processing chamber, such as a PECVD chamber 901, in which one or more films of a solar cell may be deposited. One suitable plasma enhanced chemical vapor deposition chamber is available from Applied Materials, Inc., located in Santa Clara, CA. It is contemplated that other deposition chambers, such as hot wire chemical vapor deposition (HWCVD), low-pressure chemical vapor deposition (LPCVD), physical vapor deposition (PVD), evaporation, or other similar devices, including those from other manufacturers, may be utilized to practice the present invention. In one embodiment, the chamber 901 generally includes walls 902, a bottom 904, a showerhead 910, and a substrate support 930 which define a process volume 906. The process volume is accessed through a valve 908 such that the substrate, such as substrate 102, may be transferred in and out of the PECVD chamber 901. The substrate support 930 includes a substrate receiving surface for supporting a substrate and stem 934 coupled to a lift system 936 to raise and lower the substrate support 930. A shadow frame 933 may be optionally placed over the periphery of the device substrate that may already have one or more layers formed thereon, for example, the TCO layer. Lift pins can be moveably disposed through the substrate support 930 to move a substrate to and from the substrate receiving surface. The substrate support 930 may also include heating and/or cooling elements to maintain the substrate support 930 at a desired temperature. The substrate support 930 may also include grounding straps to provide RF grounding at the periphery of the substrate support 930. Examples of grounding straps are disclosed in U.S. Patent 6,024,044 issued on Feb. 15, 2000 to Law et al. and U.S. Patent Application 11/613,934 filed on Dec. 20, 2006 to Park et al., which are both incorporated by reference in their entirety to the extent not inconsistent with the present disclosure.

The showerhead 910 is coupled to a backing plate 912 at its periphery by a suspension 914. The showerhead 910 may also be coupled to the backing plate by one or more center supports 916 to help prevent sag and/or to control the straightness/curvature of the showerhead 910. A gas source 920 is coupled to the backing plate 912 to provide gas through the backing plate 912 and through the plurality of holes 911 in the showerhead 910 to the substrate receiving surface. A vacuum pump 909 is coupled to the PECVD chamber 901 to control the process volume 906 at a desired pressure. An RF power source 922 is coupled to the backing plate 912 and/or to the showerhead 910 to provide an RF power to the showerhead 910 so that an electric field is created between the showerhead and the substrate support so that a plasma may be generated from the gases between the showerhead 910 and the substrate support 930. Various RF frequencies may be used, such as a frequency between about 0.3 MHz and about 200 MHz. In one embodiment the RF power source is provided at a frequency of 13.56 MHz. Examples of showerheads are disclosed in U.S. Patent 6,477,980 issued on November 12, 2002 to White et al., U.S. Publication 20050251990 published on November 17, 2006 to Choi et al., and U.S. Publication 2006/0060138 published on March 23, 2006 to Keller et al, which are all incorporated by reference in their entirety to the extent not inconsistent with the present disclosure.

A remote plasma source 924, such as an inductively coupled remote plasma source, may also be coupled between the gas source and the backing plate. Between processing substrates, a cleaning gas may be provided to the remote plasma source 924 so that a remote plasma is generated and provided to clean chamber components. The cleaning gas may be further excited by the RF power source 922 provided to the showerhead. Suitable cleaning gases include but are not limited to NF3, F2, and SF6. Examples of remote plasma sources are disclosed in U.S. Patent 5,788,778 issued August 4, 1998 to Shang et al, which is incorporated by reference to the extent not inconsistent with the present disclosure.

Referring back to Figure 8, in one embodiment of the system 800, one of the process chambers 881-887 is configured to deposit a p-type silicon layer(s) of a first p-i-n junction 126 or a second p-i-n junction 128 of a solar cell device, another one of the process chambers 881-887 is configured to deposit an intrinsic silicon layer of the first or the second p-i-n junction, and another of the process chambers 881-887 is configured to deposit the n-type silicon layer(s) of the first or the second p-i-n junction. While a three chamber process configuration may have some contamination control advantages, it will generally have a lower substrate throughput than a two chamber processing system, and generally cannot maintain a desirable throughput when one or more of the processing chambers is undergoing for maintenance.

In one embodiment, which can be combined with other embodiments described herein, one of the process chambers 881-887 is configured to deposit the p-type silicon layer(s) of the first p-i-n junction while the remaining process chambers 881-887 are each configured to deposit both the intrinsic-type amorphous silicon layer(s) and the n-type silicon layer(s) of the first p-i-n junction. In one embodiment, the intrinsic-type amorphous silicon layer(s) and the n-type silicon layer(s) of the first p-i-n junction 126 may be deposited in the same chamber without performing a passivation process, which is used to minimize cross-contamination between the deposited layers, in between the deposition steps. While the discussion of the processing system 800 and its components references its use in forming the various elements of the first p-i-n junction, this configuration is not intended to be limiting as to the scope of the invention described herein, since the processing system 800 could be adapted to form the first p-i-n junction, the second p-i-n junction, both the first and second p-i-n junctions, the intermediate layer, or other combinations thereof without deviating from the basic scope of the invention described herein.

In one example, in which the substrate processing sequence is performed in a system configured similarly to the processing system 800, a substrate enters the processing system 800 through the load lock chamber 860. The substrate is then transferred by the vacuum robot 872 into the process chamber 881 that is configured to deposit a p-type silicon layer(s) on the substrate. After depositing the p-type layer in process chamber 881, the substrate is then transferred by the vacuum robot 872 into the process chamber 884 that is configured to deposit both the intrinsic-type silicon layer(s) and the n-type silicon layer(s). After depositing the intrinsic-type layer(s) and n-type layer(s) in process chamber 884, the intermediate layer is deposited after the substrate is transferred to chamber 885, before a second p-i-n junction is deposited and the substrate is returned to the load lock chamber 460, after which the substrate can be removed from the system. Assuming that the p-type layer is 150Å in thickness and the deposition rate is 500Å per minute, the period of time to deposit the p-type layer is approximately 0.3 minutes. For an intrinsic layer of 2,700Å at a deposition rate of 220Å/min., the time period to deposit the intrinsic layer is approximately 12.3 minutes. Assuming an n-type layer of 250Å at a deposition rate of 500Å per minute, it will require approximately 0.5 minute to deposit the n-type layer. It can therefore be seen that if one chamber is dedicated to the deposition of a p-type layer and multiple chambers are dedicated to the deposition of the intrinsic and n-type layers, an increased throughput of substrates can be realized by increasing the number of processing chambers that can produce the i-n layers in parallel. That is, a continuous series of substrates can be loaded and maneuvered by the transfer chamber 870 from a process chamber that is adapted to deposit a p-type layer, such as process chamber 881, and then each of the substrates can be transferred to at least one subsequent processing chamber, such as process chambers 882 through 848 and 846 to 487 to form the i-n layers.

In light of the above, a plurality of embodiments has been described. According to one embodiment, a method of depositing a TCO layer on a substrate is provided. The method includes DC sputtering a ZnO-containing transparent conductive oxide layer over the substrate, the substrate having a size of 1.4 m² or above and texturing the ZnO-containing transparent conductive oxide layer, wherein the textured ZnO-containing transparent conductive oxide layer has a root means square roughness of 60 nm or below. According to optional modifications thereof, at least one of the following features can be provided of the group consisting of: the textured ZnO-containing TCO layer can have a spectral haze at 550 nm of 5 % - 20%.; the textured ZnO-containing TCO layer can have texturing angle distribution with a probability having a maximum of a texture angle α at 19° or larger, and/or the textured ZnO-containing TCO layer can have texturing angle distribution cumulative distribution function of texture angle α with a value of P(α <10°) of 15% or smaller; the method can further include depositing a barrier layer (302) between the substrate and the TCO layer, particularly wherein the barrier layer is a SiON containing layer; the method can further include conditioning the substrate before deposition on the substrate by one of the group consisting of: partly removing contaminants to expose alkali metal-containing seeds of a seed layer, cleaning the substrate with a detergent-containing alkali metal-containing seeds, polishing the substrate and combinations thereof; and the sputtering can be conducted at a substrate temperature of below 310°C.

According to a further embodiment, a method of manufacturing a precursor for a solar cell is provided. The method includes: depositing a TCO layer on a substrate, wherein the depositing includes DC sputtering a ZnO-containing transparent conductive oxide layer over the substrate, the substrate having a size of 1.4 m² or above and texturing the ZnO-containing transparent conductive oxide layer, wherein the textured ZnO-containing transparent conductive oxide layer has a root means square roughness of 60 nm or below. The method further includes depositing a layer stack including at least one p-in-junction over ZnO-containing transparent conductive oxide layer, and depositing a back contact layer. Optionally, the layer stack includes a top cell of the precursor for the solar cell and a bottom cell for the precursor of the solar cell, and wherein the top cell has an intrinsic layer with a thickness of 280 nm or below.

According to a yet further embodiment, precursor for a solar cell is provided. The precursor includes a substrate having a size of 1.4 m² or above; and a ZnO-containing transparent conductive oxide layer, which is deposited over the substrate by DC sputtering and textured, wherein the textured ZnO-containing transparent conductive oxide layer has a root means square roughness of 60 nm or below. According to optional modifications thereof, at least one of the following features can be provided of the group consisting of: the textured ZnO-containing TCO layer can have a spectral haze at 550 nm of 5 % - 20%; the textured ZnO-containing TCO layer can have a texturing angle distribution with a probability having a maximum of a texture angle α at 19° or larger, and/or the textured ZnO-containing TCO layer can have a texturing angle distribution cumulative distribution function of texture angle α with a value of P(α <10°) of 15% or smaller; the textured ZnO-containing TCO layer can have a 2D isotropic PSD, which has a first value at a wavelength of 500 nm and a second value at a wavelength of 1100 nm, wherein the second value is larger than the first value by an order of magnitude or less; the precursor can further include a barrier layer deposited between the substrate and the TCO layer, particularly wherein the barrier layer is a SiON containing layer; the precursor can further include a layer stack having at least one p-i-n-junction (126, 128) having several doped semiconductor material layers, and a back contact layer; and the layer stack can include a top cell of the precursor for the solar cell and a bottom cell for the precursor of the solar cell, and wherein the top cell has an intrinsic layer with a thickness of 280 nm or below.

While the foregoing is directed to embodiments of the present invention, other and further embodiments of the invention may be devised without departing from the basic scope thereof, and the scope thereof is determined by the claims that follow.

## Claims

1. A method of depositing a TCO layer on a substrate, the method comprising:
DC sputtering a ZnO-containing transparent conductive oxide layer over the substrate, the substrate having a size of 1.4 m² or above; and
texturing the ZnO-containing transparent conductive oxide layer,
wherein the textured ZnO-containing transparent conductive oxide layer has a root means square roughness of 60 nm or below.

2. The method according to claim 1, wherein the textured ZnO-containing TCO layer has a spectral haze at 550 nm of 5 % - 20%..

3. The method according to any of claims 1 to 2, wherein the textured ZnO-containing TCO layer has texturing angle distribution with a probability having a maximum of a texture angle α at 19° or larger, and/or wherein the textured ZnO-containing TCO layer has texturing angle distribution cumulative distribution function of texture angle α with a value of P(α <10°) of 15% or smaller.

4. The method according to any of claims 1 to 3, further comprising:
depositing a barrier layer (302) between the substrate and the TCO layer, particularly wherein the barrier layer is a SiON containing layer.

5. The method according to any of claims 1 to 4, further comprising:
conditioning the substrate (102; 801) before deposition on the substrate by one of the group consisting of: partly removing contaminants to expose alkali metal-containing seeds of a seed layer, cleaning the substrate with a detergent-containing alkali metal-containing seeds, polishing the substrate and combinations thereof.

6. The method according to any of claims 1 to 5, wherein the sputtering is conducted at a substrate temperature of below 310°C.

7. A method of manufacturing a precursor for a solar cell, the method comprising:
depositing a TCO layer on a substrate according to any of claims 1 to 6,
depositing a layer stack (126, 112, 128; 220) including at least one p-in-junction over ZnO-containing transparent conductive oxide layer, and
depositing a back contact layer (124).

8. The method according to claim 7, wherein the layer stack includes a top cell of the precursor for the solar cell and a bottom cell for the precursor of the solar cell, and wherein the top cell has an intrinsic layer with a thickness of 280 nm or below.

9. A precursor for a solar cell, comprising:
a substrate (102; 801) having a size of 1.4 m² or above; and
a ZnO-containing transparent conductive oxide layer, which is deposited over the substrate by DC sputtering and textured, wherein the textured ZnO-containing transparent conductive oxide layer has a root means square roughness of 60 nm or below.

10. The precursor according to claim 9, wherein the textured ZnO-containing TCO layer has a spectral haze at 550 nm of 5 % - 20%.

11. The precursor according to any of claims 9 to 10, wherein the textured ZnO-containing TCO layer has texturing angle distribution with a probability having a maximum of a texture angle α at 19° or larger, and/or wherein the textured ZnO-containing TCO layer has texturing angle distribution cumulative distribution function of texture angle α with a value of P(α <10°) of 15% or smaller.

12. The precursor according to any of claims 9 to 11, wherein the textured ZnO-containing TCO layer has a 2D isotropic PSD, which has a first value at a wavelength of 500 nm and a second value at a wavelength of 1100 nm, wherein the second value is larger than the first value by an order of magnitude or less.

13. The precursor according to any of claims 9 to 12, further comprising:
a barrier layer (302) deposited between the substrate and the TCO layer, particularly wherein the barrier layer is a SiON containing layer.

14. The precursor according to any of claims 9 to 13, further comprising:
a layer stack having at least one p-i-n-junction (126, 128) having several doped semiconductor material layers; and
a back contact layer (124).

15. The precursor according to claim 14, wherein the layer stack comprises a top cell of the precursor for the solar cell and a bottom cell for the precursor of the solar cell, and wherein the top cell has an intrinsic layer with a thickness of 280 nm or below.
